# FASCICULE DE BREVET EUROPEEN

(11) **EP 4 046 207 B1**
(45) Date de publication et mention de la délivrance du brevet: **19.07.2023**
(21) Numéro de dépôt: 20801334.2
(22) Date de dépôt: 14.10.2020
(51) Int. Cl.: H01L 33/42, H01L 33/32, H01L 33/18, H01L 33/00, H01L 33/08, H01L 33/04

(54) **DIODE ÉLECTROLUMINESCENTE COMPRENANT UN SEMI-CONDUCTEUR À BASE D'ALN DOPÉ P PAR DES ATOMES DE MAGNÉSIUM ET UNE COUCHE DE DIAMANT DOPÉ**
LEUCHTDIODE MIT EINEM MIT MAGNESIUMATOMEN P-DOTIERTEN ALN-BASIERTEN HALBLEITER UND EINER DOTIERTEN DIAMANTSCHICHT
LIGHT EMITTING DIODE COMPRISING A MAGNESIUM P-DOPED ALN-BASED SEMICONDUCTOR AND A DOPED DIAMOND LAYER

(30) Priorité: 17.10.2019 FR 1911616
(43) Date de publication de la demande: 24.08.2022
(73) Titulaire: COMMISSARIAT A L'ENERGIE ATOMIQUE ET AUX ENERGIES ALTERNATIVES, 75015 Paris (FR); CENTRE NATIONAL DE LA RECHERCHE SCIENTIFIQUE, 75794 Paris Cedex 16 (FR); UNIVERSITÉ GRENOBLE ALPES, 38400 Saint-Martin-d'Heres (FR)
(72) Inventeur: SILADIE, Alexandra-Madalina, 38054 GRENOBLE CEDEX 09 (FR); DAUDIN, Bruno, 38054 GRENOBLE CEDEX 09 (FR); JACOPIN, Gwénolé, 38042 GRENOBLE CEDEX 09 (FR); PERNOT, Julien, 38042 GRENOBLE CEDEX 09 (FR)
(74) Mandataire: Brevalex
(86) Numéro de dépôt international: PCT/FR2020/051809
(87) Numéro de publication internationale: WO 2021/074519

(56) Documents cités:
- US-A1- 2011 012 089
- US-A1- 2015 123 152
- US-A1- 2017 338 369
- US-A1- 2018 076 354
- US-A1- 2019 115 499
- S. ZHAO ET AL: "Aluminum nitride nanowire light emitting diodes: Breaking the fundamental bottleneck of deep ultraviolet light sources", SCIENTIFIC REPORTS, vol. 5, no. 1, 16 février 2015 (2015-02-16), pages 1-5, XP055710124, DOI: 10.1038/srep08332
- KYLE ERIN C H ET AL: "Increased p-type conductivity through use of an indium surfactant in the growth of Mg-doped GaN", APPLIED PHYSICS LETTERS, A I P PUBLISHING LLC, US, vol. 106, no. 22, 1 juin 2015 (2015-06-01) , XP012197957, ISSN: 0003-6951, DOI: 10.1063/1.4922216 [extrait le 1901-01-01]
- NAKAMURA S ET AL: "THERMAL ANNEALING EFFECTS ON P-TYPE MG-DOPED GAN FILMS", JAPANESE JOURNAL OF APPLIED PHYSICS, JAPAN SOCIETY OF APPLIED PHYSICS, JP, vol. 31, no. 2B, PART 02, 1 février 1992 (1992-02-01), pages L139-L142, XP000541252, ISSN: 0021-4922
- ALEXANDRA-MADALINA SILADIE ET AL: "Mg and In Codoped p-type AlN Nanowires for pn Junction Realization", NANO LETTERS, vol. 19, no. 12, 14 novembre 2019 (2019-11-14), pages 8357-8364, XP055710343, US ISSN: 1530-6984, DOI: 10.1021/acs.nanolett.9b01394

## Description

### DOMAINE TECHNIQUE

L'invention concerne le domaine des diodes électroluminescentes, ou LEDs (« Light-Emitting Diodes » en anglais). L'invention s'applique à la réalisation de LEDs émettant une lumière dans le domaine ultra-violet (UV).

### ÉTAT DE LA TECHNIQUE ANTÉRIEURE

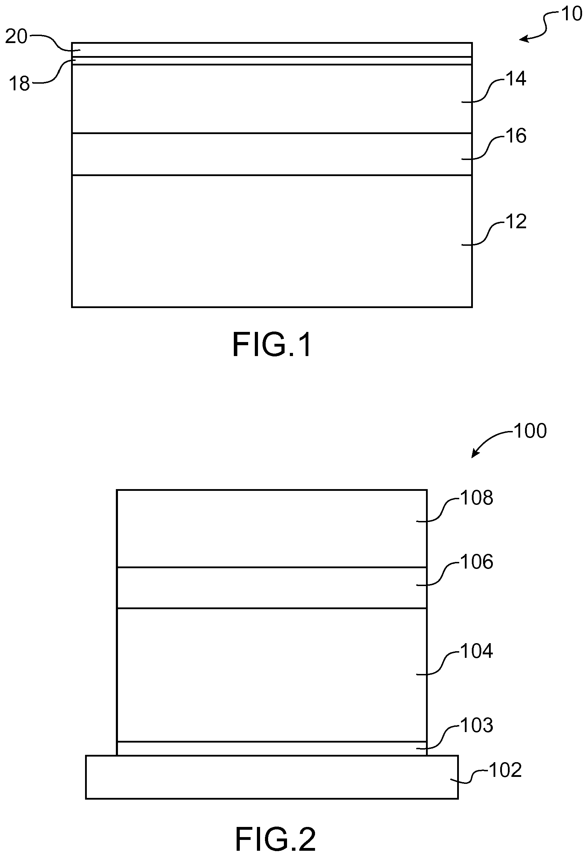

Les LEDs à base d'hétérostructures semi-conductrices émettant dans le domaine UV sont constituées d'un empilement de couches comprenant de l'AIGaN de différentes compositions. La figure 1 représente schématiquement la structure d'une telle LED 10. La LED 10 comporte une jonction p-n formée par une première couche 12 comprenant de l'AIGaN dopé n et une deuxième couche 14 comprenant de l'AIGaN dopé p. La LED 10 comporte également, entre les couches 12 et 14, une zone active 16 formant la région émissive de la LED 10, c'est-à-dire la région dans laquelle se produisent les recombinaisons d'électrons et de trous d'électrons qui engendrent l'émission de photons. La zone active 16 comprend de l'AIGaN non dopé intentionnellement. La LED 10 comporte également, sur la deuxième couche 14, une couche 18 de GaN fortement dopé p, ainsi qu'une couche 20 électriquement conductrice disposée sur la couche 18 et comportant par exemple un empilement bi-couche Ni-Au.

La composition du semi-conducteur de la zone active 16 est choisie en fonction de la longueur d'onde destinée à être émise. Pour émettre dans le domaine UV, la zone active 16 comporte de l'Al_{X}Ga_{(1-X)}N, avec X tel que 0 ≤ X ≤ 1. La première couche 12 comporte de l'Al_{Y1}Ga_{(1-Y1)}N dopé n, et la deuxième couche 14 comporte de l'Al_{Y2}Ga_{(1-Y2)}N dopé p, avec Y₁ > X et Y₂ > X.

Idéalement, réaliser les couches 12 et 14 avec de l'AIN (c'est-à-dire réalisées telles que Y₁ = 1 et Y₂ = 1) permettrait de simplifier la réalisation de la LED 10. Toutefois, la réalisation de la deuxième couche 14 dopée p avec de l'AIN pose un problème car il n'existe pas de solution technique permettant d'obtenir de l'AIN avec un niveau de dopage de type p assez grand pour assurer une conduction électrique suffisante et nécessaire au bon fonctionnement de la LED 10. Les couches 12 et 14 sont donc actuellement réalisées telles que Y₁ < 1 et Y₂ < 1.

L'injection de courant qui doit être réalisée du côté de la couche 14 de la LED 10 est une autre limitation importante. Ce problème est actuellement résolu grâce à la présence de la couche 18 de GaN fortement dopé p. Mais l'absorption du rayonnement UV émis depuis la zone active 16 par cette couche 18 limite l'efficacité de la LED 10. De plus, le dépôt de la couche 20, nécessaire pour assurer une bonne répartition latérale des lignes de courant et optimiser l'injection de courant, contribue à dégrader davantage encore l'efficacité d'émission de la LED du fait que cette couche 20 absorbe une partie de la lumière UV émise depuis la zone active 16.

Dans le document "GaN/AIGaN Nanocolumn Ultraviolet Light-Emitting Diode Using Double-Layer Graphene as Substrate and Transparent Electrode" de Ida Marie Høiaas et al., Nano Lett. 2019, 19, 3, pp. 1649-1658, le graphène est utilisé comme substrat sous la partie dopée n de la LED. Du GaN fortement dopé p est utilisé au sommet de la structure qui présente donc les mêmes inconvénients que ceux indiqués ci-dessus.

Dans le document "InGaN/GaN Core-Shell Single Nanowire Light Emitting Diodes with Graphene-Based P-Contact" de M. Tchernycheva et al., Nano Lett. 2014, 14, 5, pp. 2456-2465, il est proposé d'utiliser du graphène comme contact sur une LED formée d'un fil unique. Cette solution est bien adaptée à la structure de la LED décrite dans ce document mais est difficile à mettre en oeuvre pour des LEDs de structures différentes notamment en raison de la fragilité du graphène et des fluctuations de hauteur des fils. En outre, le graphène n'est pas déposé par épitaxie et son transfert peut se révéler compliqué. De plus, la résistance de couche (« sheet résistance » en anglais) reste élevée (~ 500 Ω /□, d'après le document «Graphene as Transparent Electrodes: Fabrication and New Emerging Applications », de Y.Xu et J. Liun Small 2016, 12, No. 11, 1400-1419).

Une autre solution consiste à réaliser la LED telle que l'émission lumineuse se fasse depuis la face arrière (du côté de la couche de semi-conducteur dopé n), à travers un substrat de saphir sur lequel les différentes couches de la LED sont réalisées. Le substrat de saphir est transparent au rayonnement UV émis. Toutefois, cela limite les possibilités de design de la LED.

Les documents US 2019/0115499 A1 et US 2018/0076354 A1 décrivent diverses structures de LEDs destinées à émettre dans l'UV.

### EXPOSÉ DE L'INVENTION

Un but de la présente invention, telle que définie par les revendications en annexe, est de proposer une diode électroluminescente ne présentant pas les inconvénients décrits ci-dessus, c'est-à-dire ne nécessitant pas la présence d'une couche de GaN fortement dopé p du côté dopé p de la LED, et dont les possibilités de design ne soient pas limitées par la nécessité de réaliser une émission lumineuse depuis la face arrière de la LED.

Pour cela, il est proposé une diode électroluminescente selon la revendication 1 en annexe, comportant au moins :
- une première portion de semi-conducteur dopé n ;
- une deuxième portion de semi-conducteur dopé p ;
- une zone active disposée entre les première et deuxième portions et comprenant au moins une portion émissive semi-conductrice ;
- une couche électriquement conductrice et optiquement transparente à au moins une longueur d'onde du domaine UV destinée à être émise depuis la portion émissive, ladite couche étant telle que la deuxième portion soit disposée entre ladite couche et la zone active;
dans laquelle :
- les semi-conducteurs de la première portion et de la portion émissive correspondent à des composés comprenant des atomes d'azote ainsi que des atomes d'aluminium et/ou de gallium ;
- le semi-conducteur de la deuxième portion correspond à de l'Al_{X2}Ga_{(1-X2-Y2)}ln_{Y2}N dopé p par des atomes de magnésium, avec X2 > 0, Y2 > 0 et X2+Y2 ≤ 1, et dans lequel la concentration atomique de magnésium est supérieure à 10¹⁷ at/cm³ ;
- la couche électriquement conductrice comporte du diamant dopé.

Il est donc proposé une LED dans laquelle, grâce au semi-conducteur de la deuxième portion qui correspond à de l'Al_{X2}Ga_{(1-X2-Y2)}In_{Y2}N dopé p par des atomes de magnésium, une couche de GaN fortement dopée p n'est pas nécessaire du côté dopé p de la LED étant donné que ce semi-conducteur de la deuxième portion permet d'obtenir une injection de courant et une répartition des lignes de courant suffisantes.

De plus, le semi-conducteur de la deuxième portion n'absorbe pas les rayonnements UV. La LED proposée est donc bien adaptée pour réaliser une émission de lumière UV, cette émission lumineuse pouvant être réalisée à travers la deuxième portion de semi-conducteur dopé p de la LED.

L'absence de la couche de GaN fortement dopé p représente également une simplification pour la réalisation de la LED.

La présence d'indium dans le semi-conducteur de la deuxième portion (qui correspond à de l'AIGalnN) permet d'incorporer, par rapport à ce même semi-conducteur ne comportant pas d'indium (c'est-à-dire de l'AIGaN), un plus grand nombre d'atomes dopants de magnésium du fait que la concentration atomique de magnésium obtenue est proportionnelle à la quantité d'indium présent dans le semi-conducteur. Ainsi, le niveau de dopage de type p pouvant être obtenu dans le semi-conducteur de la deuxième portion est plus important et permet d'obtenir une injection de courant et une répartition des lignes de courant suffisantes. La présence d'indium dans l'AIN ou l'AIGaN permet d'augmenter la solubilité limite du magnésium dans l'AIN ou l'AIGaN, par exemple d'un facteur 10, et augmente donc le niveau de dopage pouvant être obtenu dans ce semi-conducteur.

La possibilité d'incorporer un plus grand nombre d'atomes de magnésium lorsque le semi-conducteur comporte de l'indium est inattendue car ces deux types d'atomes induisent, lorsqu'ils sont introduits séparément dans de l'AIN, une contrainte compressive. Il n'y a donc pas a priori de raison pour que leur introduction simultanée soit favorable en termes d'énergie plastique accumulée car l'ajout de l'indium ne contribue pas à la relaxation de la contrainte élastique induite par l'ajout du magnésium.

De plus, selon l'invention, cette LED inclut à son sommet une couche électriquement conductrice et optiquement transparente vis-à-vis du rayonnement UV émis par la LED et qui comporte du diamant dopé. La deuxième portion est disposée entre la zone active et cette couche électriquement conductrice. L'utilisation de diamant dopé pour former une électrode transparente permet de favoriser le « spreading », c'est-à-dire l'obtention d'une répartition homogène des lignes de courant sur toute la surface de la couche d'injection de la LED formée par la deuxième portion, ce qui est favorable à l'optimisation des performances d'émission de la LED. Le choix du diamant dopé pour réaliser la couche électriquement conductrice au sommet de la LED est en outre un choix particulièrement judicieux étant donné que cela permet l'obtention de performances bien meilleures que celles obtenues avec d'autres matériaux conducteurs transparents tels que les oxydes transparents conducteurs notamment en raison de la transparence du diamant dans la gamme de l'UV-C.

Le diamant utilisé pour former cette couche électriquement conductrice peut être par exemple du diamant nanocristallin, tel que du diamant polycristallin.

Le diamant dopé de cette couche électriquement conductrice ne correspond pas à du « Diamond Like Carbon » (DLC). Le DLC est un nom attribué à une variété de matériaux carbonés amorphes dont certaines propriétés peuvent ressembler au diamant (voir par exemple le document « Diamond-like carbon: state of the art » de A. Grill, Diamond and Related Materials Volume 8, Issues 2-5, March 1999, pages 428-434). En fonction des différentes méthodes d'élaboration (et pourcentage d'hydrogénation), ce matériau peut présenter une énergie de bande interdite comprise entre 1.0 et 4.0 eV, ce qui limite son utilisation comme revêtement pour être utilisé dans le domaine infrarouge et le visible (voir le document mentionné précédemment), mais n'est pas adapté pour réaliser une couche optiquement transparente à au moins une longueur d'onde du domaine UV. De plus, bien que sa résistivité soit modulable (10²-10¹⁶ Ω/cm⁻¹), elle reste élevée. Pour cette raison, les DLC sont utilisés comme matériaux isolants et non comme matériaux électriquement conducteurs (voir le document mentionné précédemment).

L'utilisation du diamant pour réaliser une couche électriquement conductrice et transparente aux longueurs d'onde du domaine UV n'est pas évidente pour l'homme de métier. Tout d'abord, la possibilité de doper fortement le diamant de manière à former une couche électriquement conductrice n'est pas bien connue. D'autre part, l'homme de métier ne considère pas le diamant comme un matériau bon marché et dont les conditions de croissance (température, pression, taille d'échantillon) sont compatibles avec la fabrication d'une couche transparente et conductrice pour une LED.

La couche de diamant dopé permet également de dissiper la chaleur grâce aux excellentes propriétés de conduction thermique du diamant. Une telle couche de diamant dopé a également pour avantage d'être biocompatible pour des applications biomédicales (par exemple optogénétique, fluorescence, etc.).

La concentration atomique de magnésium dans le semi-conducteur de la deuxième portion peut être supérieure à 10²⁰ at/cm³. Une telle concentration atomique de magnésium est par exemple obtenue lorsque le rapport entre la concentration atomique de magnésium et la concentration atomique d'indium est comprise entre 1 et 20, ou entre 1 et 50, voire entre 1 et 100, et de préférence de l'ordre de 10.

Les semi-conducteurs de la première portion et de la portion émissive peuvent correspondre à du GaN, ou de l'AIN, ou de l'AIGaN, ou de l'InGaN, ou de l'AIGalnN.

La LED peut être telle que :
- Y2 est tel que 0 < Y2 ≤ 0,01, et/ou
- la concentration atomique de magnésium dans le semi-conducteur de la deuxième portion est comprise entre 10²⁰ at/cm³ et 10²¹ at/cm³.

La configuration ci-dessus permet d'obtenir un bon niveau de dopage de type p du semi-conducteur de la deuxième portion grâce à la baisse importante de l'énergie d'ionisation effective du magnésium à de tels niveaux de dopage, et donc une bonne injection de courant dans la LED grâce à la conduction électrique de la deuxième portion qui est proche ou similaire à celle d'une électrode métallique.

La LED peut comporter en outre :
- une troisième portion de semi-conducteur dopé n telle que la deuxième portion soit disposée entre la troisième portion et la zone active, et dans laquelle le semi-conducteur de la troisième portion correspond à de l'Al_{X3}Ga_{(1-X3-Y3)}In_{Y3}N, avec X3 > 0, Y3 > 0 et X3+Y3 ≤ 1.

La LED peut comporter en outre une troisième portion de semi-conducteur dopé n disposée entre la couche électriquement conductrice et la deuxième portion, et dans laquelle le semi-conducteur de la troisième portion correspond à de l'Al_{X3}Ga_{(1-X3-Y3)}In_{Y3}N, avec X3 > 0, Y3 > 0 et X3+Y3 ≤ 1.

Une telle troisième portion et/ou la couche indiquées ci-dessus forment une électrode transparente sur la structure de la LED qui permet de faciliter la prise de contact tout en restant transparent à la longueur d'onde émise, notamment lorsque cette longueur d'onde est dans le domaine de l'UV. La réalisation de la troisième portion est possible grâce au semi-conducteur de la deuxième portion qui est de même nature chimique que celui de la troisième portion. La troisième portion permet de réaliser une injection de courant par effet tunnel dans la LED. De plus, la troisième portion et/ou ladite couche permettent de favoriser le « spreading », c'est-à-dire l'obtention d'une répartition homogène des lignes de courant sur toute la surface de la couche d'injection de la LED, favorable à l'optimisation de la LED. En outre, lorsque la LED comporte à la fois la troisième portion et la couche électriquement conductrice et optiquement transparente, la troisième portion peut être disposée entre la deuxième portion et ladite couche électriquement conductrice et optiquement transparente

La couche électriquement conductrice et optiquement transparente à au moins une longueur d'onde destinée à être émise depuis la portion émissive correspond à une couche de diamant dopé, par exemple d'épaisseur inférieure à 150 nm et préférentiellement de l'ordre de 60 nm. Le diamant dopé peut correspondre à du diamant polycristallin dopé dans lequel la concentration de dopants est par exemple égale à 2,7.10¹⁹ at/cm³ ou plus généralement comprise entre 1.10¹⁵ et 2.10²¹ at/cm³, permettant d'obtenir une conductivité électronique par exemple comprise entre 1.5×10⁻⁸ Ω⁻¹m⁻¹ et 75.1 Ω⁻¹m⁻¹. Les dopants utilisés correspondent par exemple à des atomes de bore. L'absorption optique obtenue vis-à-vis de la ou des longueurs d'onde destinées à être émise depuis la portion émissive est dans ce cas inférieure à environ 25 % en considérant par exemple une couche de diamant dopé d'épaisseur égale à 60 nm, avec un coefficient d'absorption variant entre 1.10⁴ cm⁻¹ et 5.10⁴ cm⁻¹ pour une longueur d'onde de 310 nm.

De manière générale, la couche électriquement conductrice et optiquement transparente, comportant du diamant dopé, présente, vis-à-vis de la ou des longueurs d'onde destinées à être émise depuis la ou les portions émissives, une absorption optique inférieure à environ 25 %.

Le semi-conducteur de la première portion peut correspondre à de l'Al_{X1}Ga_{(1-X1)}N, avec 0 ≤ X1 ≤ 1, avec préférentiellement 0,7 ≤ X1 ≤ 0,9. La valeur de bande interdite (gap) est dans ce cas supérieure à celle de la zone active.

Les semi-conducteurs des première et deuxièmes portions peuvent être tels que X2 = X1.

Le semi-conducteur de la portion émissive peut correspondre à de l'Al_{X4}Ga_{(1-X4)}N, avec X4 ≤ 0,9.X1. Ainsi, le semi-conducteur de la portion émissive est tel que la lumière émise par la LED appartienne au domaine de l'UV, notamment entre 210 nm et 340 nm ou entre 210 nm et 400 nm, et plus particulièrement dans le domaine UV-C, c'est-à-dire entre 210 nm et 280 nm. Par exemple, la LED peut émettre une lumière de longueur d'onde comprise entre 260 nm et 270 nm afin que cette lumière émise par la LED ait des propriétés bactéricides, la LED pouvant être utilisée par exemple pour des applications de purification de l'air et/ou de l'eau. Selon un autre exemple, le semi-conducteur de la portion émissive peut être tel que la longueur d'onde de la lumière émise depuis la zone active de la LED soit égale à 315 nm, rendant la LED adaptée à une utilisation médicale, par exemple pour le traitement du psoriasis. De plus, la structure de cette LED permet d'atteindre de très courtes longueurs d'onde, par exemple égale à 210 nm.

La LED peut comporter en outre :
- une portion d'AlGaN non intentionnellement dopé disposée entre la première portion et la zone active, et/ou
- une portion d'AIGalnN non intentionnellement dopé disposée entre la zone active et la deuxième portion.

Cette configuration permet de mieux définir spatialement la zone de recombinaison des porteurs de charge. En outre, la portion d'AIGalnN non intentionnellement dopée disposée entre le zone active et la deuxième portion sert de couche de blocage d'électrons (ou EBL pour « Electron Blocking Layer ») pour éviter le surplus d'électrons dans la zone dopée p.

Un semi-conducteur non intentionnellement dopé, ou nid, correspond à un semi-conducteur n'ayant pas subi d'étape de dopage au cours de laquelle des atomes dopants sont introduits dans le semi-conducteur.

La LED peut comporter en outre un substrat tel que la première portion soit disposée entre le substrat et la zone active.

De plus, la LED peut comporter en outre au moins une portion de GaN dopé n disposée entre le substrat et la première portion. La portion de GaN dopé n permet dans ce cas d'initier une croissance de nanofils avant le dépôt de portions d'AlGaN. Elle permet notamment de faire appel à tout type de substrat : semi-conducteur, amorphe, ou métallique.

La diode peut comporter un empilement de couches formant les différentes portions de la diode, ou plusieurs nanofils disposés les uns à côté des autres et formant ensemble les différentes portions de la diode.

Lorsque la diode comporte plusieurs nanofils disposés les uns à côté des autres et formant ensemble les différentes portions de la diode, les dimensions latérales des parties des nanofils formant la deuxième portion sont telles qu'elles forment, aux sommets des nanofils, une couche de semi-conducteur. Dans ce cas, les sommets des nanofils ont des dimensions latérales plus importantes amenant ces sommets à être en contact les uns avec les autres de manière à former la couche de semi-conducteur. Cette couche de semi-conducteur peut avantageusement former un support pour la réalisation de la troisième portion de semi-conducteur dopé n et de la couche électriquement conductrice et optiquement transparente. Les dimensions latérales des nanofils correspondent aux dimensions des nanofils qui sont sensiblement perpendiculaires à leur longueur, la longueur correspondant à leur plus grande dimension. En variante, ce support pour la réalisation de la couche électriquement conductrice et optiquement transparente et éventuellement de la troisième portion de semi-conducteur dopé n pourrait être formé d'une autre façon, par exemple en remplissant l'espace entre les nanofils par un matériau isolant et non optiquement absorbant.

La zone active peut comporter une ou plusieurs couches de boîtes quantiques chacune formée d'une couche émissive disposée entre deux couches barrières.

Il est également proposé un procédé, selon la revendication 12 en annexe, de réalisation d'une diode électroluminescente, comportant au moins :
- réalisation d'une première portion de semi-conducteur dopé n ;
- réalisation d'une zone active sur la première portion et comprenant au moins une portion émissive semi-conductrice ;
- réalisation d'une deuxième portion de semi-conducteur dopé p sur la zone active ;
- réalisation, sur la deuxième portion, d'une couche électriquement conductrice et optiquement transparente à au moins une longueur d'onde du domaine UV destinée à être émise depuis la portion émissive ;
dans lequel :
- les semi-conducteurs de la première portion et de la portion émissive correspondent à des composés comprenant des atomes d'azote ainsi que des atomes d'aluminium et/ou de gallium ;
- le semi-conducteur de la deuxième portion correspond à de l'Al_{X2}Ga_{(1-X2-Y2)}ln_{Y2}N dopé p par des atomes de magnésium, avec X2 > 0, Y2 > 0 et X2+Y2 ≤ 1, et dans lequel la concentration atomique des atomes de magnésium est supérieure à 10¹⁷ at/cm³;
- la couche électriquement conductrice comporte du diamant dopé.

La croissance de cette couche peut être par exemple réalisée par dépôt chimique en phase vapeur (chemical vapor deposition, i.e. CVD). Une couche continue de diamant polycristallin est alors obtenue par coalescence des nanocristaux de diamant crûs sur la surface.

La réalisation de la deuxième portion peut comporter la mise en oeuvre d'un dépôt chimique en phase vapeur aux organométalliques (ou MOCVD pour « MetalOrganic Chemical Vapor Déposition » en anglais) et/ou d'une épitaxie par jets moléculaires, EJM (ou MBE pour « Molecular Beam Epitaxy » en anglais).

Le procédé peut comporter en outre, après la réalisation de la deuxième portion :
- réalisation d'une troisième portion de semi-conducteur dopé n sur la deuxième portion, le semi-conducteur de la troisième portion correspondant à de l'Al_{X3}Ga_{(1-X3-Y3)}In_{Y3}N, avec X3 > 0, Y3 > 0 et X3+Y3 ≤ 1.

Lorsque la troisième portion et la couche électriquement conductrice sont réalisées, la troisième portion est réalisée avant la couche électriquement conductrice, cette dernière étant réalisée ensuite sur la troisième portion.

Le procédé peut comporter en outre, après la réalisation de la deuxième portion, une étape d'activation des dopants du semi-conducteur de la deuxième portion incluant un recuit thermique et/ou une irradiation par faisceau électronique de la deuxième portion.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente une LED selon l'art antérieur ;
- la figure 2 représente une LED, objet de la présente invention, selon un premier mode de réalisation ;
- la figure 3 représente une LED, objet de la présente invention, selon un deuxième mode de réalisation ;
- la figure 4 représente une LED, objet de la présente invention, selon un troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

Une LED 100 selon un premier mode de réalisation est décrite ci-dessous en lien avec la figure 2. Dans ce premier mode de réalisation, les différentes portions de matériaux formant la LED 100 sont réalisées sous la forme de couches empilées les unes sur les autres et réalisées par la mise en oeuvre successive d'étapes d'épitaxie.

La LED 100 comporte un substrat 102. Dans ce premier mode de réalisation, le substrat 102 comporte par exemple du saphir. D'autres types de substrat peuvent être utilisés, comprenant par exemple un matériau semi-conducteur.

Avantageusement, la LED 100 comporte une portion 103 de GaN dopé n formée sur le substrat 102.

La LED 100 comporte également une première portion 104 de semi-conducteur dopé n disposée sur la portion 103 (ou directement sur le substrat 102 lorsque la LED 100 ne comporte pas la portion 103). Le semi-conducteur de la première portion 104 correspond à un composé comprenant des atomes d'azote ainsi que des atomes d'aluminium et/ou de gallium. Le semi-conducteur de la première portion 104 correspond à de l'Al_{X1}Ga_{(1-X1)}N, avec 0 ≤ X1 ≤ 1, avec préférentiellement 0,7 ≤ X1 ≤ 0,9. Le semi-conducteur de la première portion 104 peut comporter également des atomes d'indium, le composé de la première portion 104 pouvant correspondre dans ce cas à de l'AIGalnN ou de l'InGaN.

Selon un exemple de réalisation, le dopage de type n du semi-conducteur de la première portion 104 est obtenu par incorporation d'atomes de silicium dans le semi-conducteur de la première portion 104 lors de la croissance de ce semi-conducteur. La concentration de dopants dans le semi-conducteur de la première portion 104 est par exemple comprise entre 10¹⁷ at/cm³ et 10¹⁹ at/cm³.

L'épaisseur de la première portion 104 est par exemple égale à 1 µm, et plus généralement comprise entre 0,5 et 5 µm.

La LED 100 comporte également une zone active 106 disposée sur la première portion 104. Cette zone active 106 comporte au moins une portion émissive semi-conductrice depuis laquelle une lumière est destinée à être émise. Le semi-conducteur de la portion émissive correspond à un composé comprenant des atomes d'azote ainsi que des atomes d'aluminium et/ou de gallium. Par exemple, le semi-conducteur de la portion émissive correspond à de l'Al_{X4}Ga_{(1-X4)}N, avec X4 < X1, et préférentiellement X4 ≤ 0,1.X1. Ce semi-conducteur n'est pas intentionnellement dopé, c'est-à-dire n'est pas soumis, lors de la réalisation de la LED 100, à une étape introduisant des atomes dopants dans le semi-conducteur.

L'épaisseur de la zone active 106 est par exemple égale à 100 nm, et plus généralement comprise entre environ 100 nm et 300 nm.

Dans le cadre de la présente invention, la valeur de X4 est choisie telle que la longueur d'onde de la lumière émise depuis la portion émissive de la zone active 106 appartienne au domaine de l'UV, notamment entre environ 210 nm et 340 nm, et plus particulièrement de l'UV-C (c'est-à-dire entre 210 nm et 280 nm), ce qui correspond à X4 tel que 0,7 < X4 < 1.

Selon une variante de réalisation, la LED 100 peut comporter une portion d'AlGaN non intentionnellement dopé disposée entre la première portion 104 et la zone active 106, et dont l'épaisseur est par exemple égale à 20 nm. Cette portion d'AlGaN n'est pas représentée sur la figure 2.

La LED 100 comporte également une deuxième portion 108 de semi-conducteur dopé p disposée sur la zone active 106. Le semi-conducteur de la deuxième portion 108 correspond à de l'Al_{X2}Ga_{(1-X2-Y2)}In_{Y2}N dopé p par des atomes de magnésium, avec X2 > 0, Y2 > 0 et X2+Y2 ≤ 1. De manière avantageuse, le semi-conducteur de la deuxième portion 108 est tel que X2 = X1. De plus, il est avantageux d'avoir 0 < Y2 ≤ 0,01, et préférentiellement Y2 = 0,001.

La concentration de dopants dans le semi-conducteur de la deuxième portion 108 est par exemple comprise entre environ 10¹⁸ at/cm³ et 10²¹ at/cm³.

L'épaisseur de la deuxième portion 108 est par exemple égale à 1 µm, et plus généralement comprise entre environ 0,2 µm et 1 µm.

La deuxième portion 108 peut être réalisée par MOCVD ou MBE.

Lors d'une croissance par MBE, des flux des différents éléments chimiques du semi-conducteur à réaliser sont envoyés sur la surface de croissance. Pour la croissance du semi-conducteur de la deuxième portion 108, des flux d'aluminium, d'azote actif, d'indium et éventuellement de gallium sont envoyés sur la surface de croissance qui correspond à la surface supérieure de la zone active 106. Un flux de magnésium est également envoyé pour que le semi-conducteur réalisé soit dopé p par les atomes de magnésium. Les valeurs de ces flux, c'est-à-dire la quantité d'atomes envoyés de chacun de ces éléments chimiques, sont choisies en fonction de la composition souhaitée pour le semi-conducteur de la deuxième portion 108 et notamment de telle façon que la concentration atomique d'indium soit comprise entre 0 et 1% et préférentiellement égale à 0,1%. En présence de ce flux d'indium, la concentration atomique de magnésium dans le semi-conducteur de la deuxième portion 108 est proportionnelle à la quantité d'indium incorporée dans ce semi-conducteur et est par exemple comprise entre 10¹⁷ at/cm³ et 10²¹ at/cm³, et avantageusement comprise entre 10²⁰ at/cm³ et 10²¹ at/cm³, soit une concentration atomique de magnésium comprise entre 0,1 % et 1 %.

Lors d'une croissance par MOCVD, les éléments constitutifs utilisés pour la croissance du semi-conducteur sont des précurseurs organométalliques, par exemple du triméthylaluminium ou du triéthylaluminium servant de source d'aluminium, de l'ammoniac servant de source d'azote, du triméthylindium ou du triéthylindium servant de source d'indium, et éventuellement du triméthylgallium ou du triéthylgallium servant de source de gallium. Les atomes de magnésium sont obtenus par un précurseur approprié, par exemple une solution de magnésocène ou Mg(Cp)z. Les concentrations d'indium et de magnésium pouvant être obtenues par MOCVD peuvent être similaires à celles obtenues par MBE.

Selon une variante de réalisation, la LED 100 peut comporter une portion d'AIGalnN non intentionnellement dopé disposée entre la zone active 106 et la deuxième portion 108, et dont l'épaisseur est par exemple égale à 20 nm. Cette portion d'AIGalnN n'est pas représentée sur la figure 2. Cette portion d'AIGalnN non intentionnellement dopé sert de couche de blocage d'électrons qui permet d'éviter le surplus d'électrons dans la zone dopée p et favoriser la recombinaison des porteurs de charge dans la zone active.

Pour ce premier mode de réalisation, les différentes portions de la LED 100 peuvent être réalisées en mettant en oeuvre plusieurs étapes successives d'épitaxie.

Après la réalisation de la deuxième portion 108, une étape d'activation des dopants de type p (c'est-à-dire les atomes de magnésium) présents dans le semi-conducteur de la deuxième portion 108 est mise en oeuvre. Cette étape d'activation peut correspondre à la mise en oeuvre d'un recuit thermique et/ou d'une irradiation par faisceau électronique de la deuxième portion 108. Le recuit thermique est par exemple réalisé à une température comprise entre 100°C et 1000°C, et préférentiellement égale à 700°C. L'irradiation par faisceau électronique consiste à envoyer un ou plusieurs faisceaux d'électrons sur la LED 100, à travers la face supérieure de la LED 100 formée par la deuxième portion 108, l'énergie des électrons étant choisie pour limiter leur pénétration dans le semi-conducteur de la deuxième portion 108 afin que les électrons n'atteignent pas les matériaux se trouvant sous la deuxième portion 108. Cette énergie des électrons est par exemple égale à 3 keV, ou plus généralement comprise entre environ 2 keV et 30 keV et choisie notamment en fonction de l'épaisseur de la deuxième portion 108. La dose est fixée par la valeur du courant du faisceau d'électrons et peut varier entre 1 mA/cm² et 20 mA/cm², et est préférentiellement égale à 7 mA/cm². Cette irradiation électronique est réalisée pendant une durée par exemple égale à 10 minutes.

Bien que non représentée sur la figure 2, la LED 100 d'après la présente invention comporte également une couche électriquement conductrice et optiquement transparente à au moins une longueur d'onde du domaine UV destinée à être émise depuis la portion émissive de la LED 100. La deuxième portion 108 est disposée entre cette couche électriquement conductrice et la zone active 106. Cette couche électriquement conductrice comporte, d'après la présente invention, du diamant dopé.

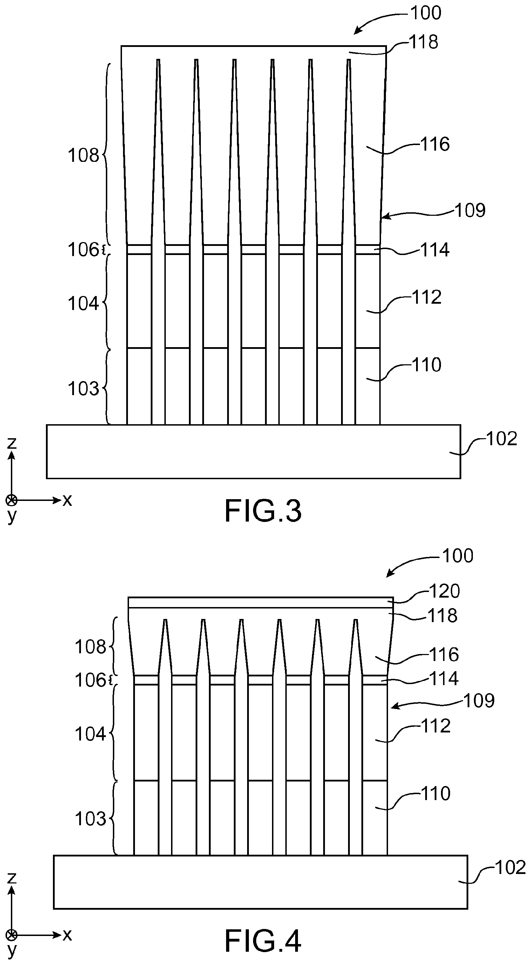

Une LED 100 selon un deuxième mode de réalisation est décrite ci-dessous en lien avec la figure 3. Dans ce deuxième mode de réalisation, les différentes portions de matériaux de la LED 100 sont formées par des nanofils 109 disposés les uns à côté des autres sur le substrat 102. Chaque nanofil 109 comporte plusieurs parties réalisées successivement, par exemple par épitaxie, comprenant des compositions de matériaux différentes et formant les différentes portions de matériaux de la LED 100. Dans la description ci-dessous, le terme « longueur » de chaque partie des nanofils 109 correspond à la dimension de cette partie des nanofils 109 qui est perpendiculaire à la surface sur laquelle les nanofils 109 sont réalisés, et qui est parallèle à l'axe Z représenté sur la figure 3. Les longueurs des différentes parties des nanofils correspondent aux épaisseurs des différentes portions de la LED 100.

Comme dans le premier mode de réalisation, la LED 100 comporte le substrat 102. Dans ce deuxième mode de réalisation, le substrat 102 comporte un matériau électriquement conducteur, comme par exemple du silicium dopé n.

Les nanofils 109 de la LED 100 sont ici réalisés par croissance depuis une face avant du substrat 102, soit par nucléation spontanée ou, préférentiellement, sur des parties du substrat 102 définies au préalable par masquage. Les nanofils 109 de la LED 100 sont par exemple réalisés par MBE.

Chaque nanofil 109 comporte une première partie 110 formée sur le substrat 102 et comprenant du GaN dopé n. Ces premières parties 110 forment ensemble la portion 103 de GaN dopé n. Chaque première partie 110 a par exemple une longueur comprise entre 100 nm et 500 nm.

Chaque nanofil 109 comporte également une deuxième partie 112 réalisée sur la première partie 110. Ces deuxièmes parties 112 forment ensemble la première portion 104 de semi-conducteur dopé n. Le semi-conducteur des deuxièmes parties 112 des nanofils 109 correspond à un composé comprenant des atomes d'azote ainsi que des atomes d'aluminium et/ou de gallium. Le semi-conducteur des deuxièmes parties 112 correspond à de l'Al_{X1}Ga_{(1-X1)}N, avec 0 ≤ X1 ≤ 1, et préférentiellement 0,7 ≤ X1 ≤ 0,9.

Selon un exemple de réalisation, le dopage de type n du semi-conducteur des deuxièmes parties 112 des nanofils 109 est obtenu par incorporation d'atomes de silicium dans le semi-conducteur de ces deuxièmes parties 112 lors de leur croissance. La concentration de dopants dans le semi-conducteur des deuxièmes parties 112 des nanofils 109 est par exemple comprise entre 10¹⁷ at/cm³ et 10¹⁸ at/cm³, et plus généralement entre 10¹⁶at/cm³ et 10²⁰ at/cm³.

Chaque deuxième partie 112 a par exemple une longueur comprise entre 100 nm et 500 nm.

Selon une variante de réalisation, les nanofils 109 peuvent ne pas comporter les premières parties 110. Dans ce cas, le matériau des nanofils 109 réalisé contre le substrat 102 correspond à celui des deuxièmes parties 112.

Chaque nanofil 109 comporte également une troisième partie 114 réalisée sur la deuxième partie 112. Les troisièmes parties 114 des nanofils 109 forment ensemble la zone active 106 de la LED 100, et forment notamment une portion émissive semi-conductrice de la zone active 106 depuis laquelle une lumière est destinée à être émise. Le semi-conducteur de la portion émissive correspond à un composé comprenant des atomes d'azote ainsi que des atomes d'aluminium et/ou de gallium. Par exemple, le semi-conducteur de la portion émissive correspond à de l'Al_{X4}Ga_{(1-X4)}N, avec X4 < X1, et préférentiellement X4 ≤ 0,1.X1. Ce semi-conducteur n'est pas intentionnellement dopé, c'est-à-dire n'est pas soumis, lors de la réalisation de la LED 100, à une étape introduisant des atomes dopants dans le semi-conducteur.

Chaque troisième partie 114 a par exemple une longueur égale à 100 nm.

Selon une variante de réalisation, chaque nanofil 109 peut comporter une portion d'AlGaN non intentionnellement dopé disposée entre la deuxième partie 112 et la troisième partie 114, et dont l'épaisseur est par exemple égale à 20 nm. Cette portion d'AlGaN n'est pas représentée sur la figure 3.

Chaque nanofil 109 comporte également une quatrième partie 116 réalisée sur la troisième partie 114. Les quatrièmes parties 116 des nanofils 109 forment ensemble la deuxième portion 108 de semi-conducteur dopé p disposée sur la zone active 106. Le semi-conducteur des quatrièmes parties 116 correspond à de l'Al_{X2}Ga_{(1-X2-Y2)}In_{Y2}N dopé p par des atomes de magnésium, avec X2 > 0, Y2 > 0 et X2+Y2 ≤ 1. De manière avantageuse, le semi-conducteur des quatrièmes parties 116 est tel que X2 = X1. De plus, il est avantageux d'avoir 0 < Y2 ≤ 0,01, et préférentiellement Y2 = 0,001.

La concentration de dopants dans le semi-conducteur de la deuxième portion 108 est par exemple comprise entre environ 10¹⁸ at/cm³ et 10²¹ at/cm³.

Chaque quatrième partie 116 a par exemple une longueur comprise entre 100 nm et 500 nm.

Selon une variante de réalisation, chaque nanofil 109 peut comporter une portion d'AIGalnN non intentionnellement dopé disposée entre la troisième partie 114 et la quatrième partie 116, et dont l'épaisseur est par exemple égale à 20 nm. Cette portion d'AIGalnN n'est pas représentée sur la figure 3.

De manière avantageuse, les quatrièmes parties 116 des nanofils 109 sont réalisées telles qu'à leur sommet, ces quatrièmes parties 116 aient des dimensions latérales (dimensions dans le plan (X,Y)) qui augmentent et qu'elles se rejoignent en étant physiquement en contact les unes avec les autres. Cette configuration permet de former, au sommet des nanofils 109, une couche 118 comprenant le matériau des quatrièmes parties 116 des nanofils 109. Cette configuration est par exemple obtenue en modifiant, lors de la croissance des nanofils 109 par MBE, le rapport entre les flux métalliques (correspondant aux flux d'aluminium et d'indium, et éventuellement du flux de gallium) et le flux d'azote. Il est par exemple possible augmenter le flux métallique de 50 % pour obtenir la couche 118. Cela permet d'éviter de déposer du matériau dopé de type p sur le flanc des nanofils 109 en minimisant le risque de court-circuit électrique avec la partie basse de la LED 100. L'obtention de cette couche 118 est par exemple obtenue lorsque l'espacement entre deux nanofils 109 est inférieur à environ deux fois le diamètre d'un des nanofil 109.

Comme pour le premier mode de réalisation, après la réalisation des quatrièmes parties 116 des nanofils 109 (et éventuellement de la couche 118 si une telle couche est réalisée), une étape d'activation des dopants de type p (c'est-à-dire les atomes de magnésium) présents dans le semi-conducteur des quatrièmes parties 116 des nanofils 109 est mise en oeuvre. Cette étape d'activation peut correspondre à la mise en oeuvre d'un recuit thermique et/ou d'une irradiation par faisceau(x) électronique(s), de manière similaire à ce qui a été précédemment décrit pour le premier mode de réalisation.

Bien que non représentée sur la figure 3, la LED 100 selon ce deuxième mode de réalisation comporte également, d'après la présente invention, une couche électriquement conductrice et optiquement transparente à au moins une longueur d'onde du domaine UV destinée à être émise depuis la portion émissive de la LED 100. Z Cette couche électriquement conductrice est disposée sur la couche 118. Cette couche électriquement conductrice comporte, selon la présente invention, du diamant dopé.

Une LED 100 selon un troisième mode de réalisation est décrite ci-dessous en lien avec la figure 4.

Comme dans le deuxième mode de réalisation, les différentes portions de matériaux formant la LED 100 sont formées par des nanofils 109 disposés les uns à côté des autres sur le substrat 102. Chaque nanofil 109 comporte plusieurs parties réalisées successivement, comprenant des matériaux de compositions différentes et formant les différentes portions de matériaux de la LED 100.

Les nanofils 109 de la LED 100 selon le troisième mode de réalisation sont similaires à ceux précédemment décrits pour la LED 100 selon le deuxième mode de réalisation, et comportent les parties 110, 112, 114 et 116 et forment également, à leurs sommets, la couche 118.

La LED 100 selon ce troisième mode de réalisation comporte également, sur la couche 118, une couche d'Al_{X3}Ga_{(1-X3-Y3)}In_{Y3}N dopé n, avec X3 > 0, Y3 > 0 et X3+Y3 ≤ 1. Cette couche est appelée ici troisième portion de semi-conducteur dopé n de la LED 100 et n'est pas visible sur la figure 4. De manière avantageuse, la concentration atomique X3 d'aluminium dans le semi-conducteur de la troisième portion est égale à la concentration atomique X1 d'aluminium dans le semi-conducteur de la première portion 104. Les dopants de type n présents dans le semi-conducteur de la troisième portion correspondent par exemple à des atomes de silicium ou de germanium. La concentration de dopants dans le semi-conducteur de la troisième portion est par exemple comprise entre environ 10¹⁷ at/cm³ et 10²⁰ at/cm³. L'épaisseur de la troisième portion est par exemple égale à 100 nm, et plus généralement comprise entre environ 50 nm et 200 nm. Cette troisième portion permet de réaliser une injection de courant par effet tunnel dans la LED 100.

Il est également possible que la concentration atomique X3 d'aluminium dans le semi-conducteur de la troisième portion soit inférieure à la concentration atomique X1 d'aluminium dans le semi-conducteur de la première portion 104. Cela permet d'atteindre, dans le semi-conducteur de la troisième portion, un niveau de dopage plus important tout en assurant la transparence de cette troisième portion vis-à-vis de la longueur d'onde d'émission de la LED 100 lorsque la LED 100 émet dans le domaine UV, conformément à la présente invention.

D'après la présente invention telle que revendiquée, la LED 100 peut ne pas comporter cette troisième portion mais elle comporte, en revanche, une couche 120 comprenant non pas de l'AlGaInN mais du diamant dopé, électriquement conducteur et transparent à la longueur d'onde émise par la LED 100, en l'occurrence à au moins une longueur d'onde du domaine UV. La couche 120 électriquement conductrice comporte du diamant dopé, par exemple du diamant polycristallin dopé dont l'épaisseur est par exemple égale à 100 nm. Plus généralement, l'épaisseur de la couche 120 est comprise entre 30 nm et 500 nm.

Une telle couche 120 est présente, d'après l'invention telle que définie par les revendications, dans la LED 100 selon le premier mode de réalisation. De plus, lorsque la LED 100 comporte des nanofils 109 qui ne forment pas, à leurs sommets, la couche 118, il est possible que chacun des nanofils 109 comporte, à son sommet, une partie comprenant de l'Al_{X3}Ga_{(1-X3-Y3)}In_{Y3}N dopé n, avec X3 > 0, Y3 > 0 et X3+Y3 ≤ 1 et formant la troisième portion précédemment décrite.

Cette couche 120, comportant du diamant dopé, permet de former une électrode transparente sur la structure de la LED 100 qui permet de faciliter la prise de contact tout en restant transparent à la longueur d'onde émise. Elle favorise également l'obtention d'une répartition homogène des lignes de courant sur toute la surface de la couche d'injection de la LED 100, favorable à l'optimisation de la LED 100.

Dans les trois modes de réalisation de la présente invention précédemment décrits, la zone active 106 comporte une portion émissive comprenant un composé formé d'atomes d'azote ainsi que d'atomes d'aluminium et/ou de gallium. En variante, il est possible que la zone active 106 de la LED 100 comporte un ou plusieurs puits quantiques chacun formé d'une couche émissive disposée entre deux couches barrières. Dans ce cas, le semi-conducteur de la couche émissive ou de chaque couche émissive et le semi-conducteur de chacune des couches barrières peuvent correspondre à de l'AIGaN, avec toutefois, dans le semi-conducteur des couches émissives, une concentration atomique d'aluminium inférieure à celle dans le semi-conducteur des couches barrières, et préférentiellement inférieure à 10 % de celle dans le semi-conducteur des couches barrières.

Dans une autre variante, il est possible que la zone active 106 de la LED 100 comporte une ou plusieurs couches de boîtes quantiques chacune formée d'une couche émissive disposée entre deux couches barrières. Dans ce cas, le semi-conducteur de la couche émissive ou de chaque couche émissive et le semi-conducteur de chacune des couches barrières peuvent correspondre à de l'AIGaN, avec toutefois, dans le semi-conducteur des couches émissives, une concentration atomique d'aluminium inférieure à celle dans le semi-conducteur des couches barrières, et préférentiellement inférieure de 10 % à celle dans le semi-conducteur des couches barrières. La couche émissive ou chacune des couches émissives peut également comporter dans ce cas des couches monoatomiques de GaN et d'AIN superposées telles que la proportion, ou composition, d'aluminium dans l'alliage moyen de ces couches soit inférieure à celle dans le semi-conducteur des couches barrières, et préférentiellement inférieure à 10 % de celle dans le semi-conducteur des couches barrières. La proportion d'un élément atomique de « l'alliage moyen » de ces couches se calcule en prenant compte de la proportion de cet élément dans chacune de ces couches et en pondérant ces concentrations par les épaisseurs des couches. Par exemple, en considérant un empilement de couches comprenant une couche de GaN d'épaisseur égale à 2 nm et une couche d'AIN d'épaisseur égale à 1 nm, cet empilement de couches étant répété plusieurs fois, la proportion d'aluminium dans l'alliage moyen est 33%, c'est-à-dire que l'alliage moyen correspond à de l'Al_{0,33}Ga_{0,67}N. Dans ce cas, lorsque cette proportion d'aluminium est préférentiellement inférieure à 10 % de celle dans le semi-conducteur des couches barrières, la proportion d'aluminium dans le semi-conducteur des couches barrières est égale à 33 % + 3,3 % = 36,3 %.

L'objet de la présente invention est défini par les revendications qui suivent.

## Revendications

1. Diode électroluminescente (100) comportant au moins :
- une première portion (104) de semi-conducteur dopé n ;
- une deuxième portion (108) de semi-conducteur dopé p ;
- une zone active (106) disposée entre les première et deuxième portions (104, 108) et comprenant au moins une portion émissive semi-conductrice ;
- une couche (120) électriquement conductrice et optiquement transparente à au moins une longueur d'onde du domaine UV destinée à être émise depuis la portion émissive, ladite couche (120) étant telle que la deuxième portion (108) soit disposée entre ladite couche (120) et la zone active (106) ;
dans laquelle :
- les semi-conducteurs de la première portion (104) et de la portion émissive correspondent à des composés comprenant des atomes d'azote ainsi que des atomes d'aluminium et/ou de gallium ;
- le semi-conducteur de la deuxième portion (108) correspond à de l'Al_{X2}Ga_{(1-X2-Y2)}In_{Y2}N dopé p par des atomes de magnésium, avec X2 > 0, Y2 > 0 et X2+Y2 ≤ 1, et dans lequel la concentration atomique de magnésium est supérieure à 10¹⁷ at/cm³;
la diode électroluminescente (100) étant **caractérisée en ce que** la couche (120) électriquement conductrice comporte du diamant dopé.

2. Diode électroluminescente (100) selon la revendication 1, dans laquelle :
- Y2 est tel que 0 < Y2 ≤ 0,01, et/ou
- la concentration atomique de magnésium dans le semi-conducteur de la deuxième portion (108) est comprise entre 10²⁰ at/cm³ et 10²¹ at/cm³.

3. Diode électroluminescente (100) selon l'une des revendications précédentes, comportant en outre une troisième portion de semi-conducteur dopé n disposée entre la couche électriquement conductrice (120) et la deuxième portion (108), et dans laquelle le semi-conducteur de la troisième portion correspond à de l'Al_{X3}Ga_{(1-X3-Y3})In_{Y3}N, avec X3 > 0, Y3 > 0 et X3+Y3 < 1.

4. Diode électroluminescente (100) selon l'une des revendications précédentes, dans lequel le semi-conducteur de la première portion (104) correspond à de l'Al_{X1}Ga_{(1-X1)}N, avec 0,7 ≤ X1 ≤ 0,9.

5. Diode électroluminescente (100) selon la revendication précédente, dans laquelle le semi-conducteur de la portion émissive correspond à de l'Al_{X4}Ga_{(1-X4)}N, avec X4 ≤ 0,9.X1.

6. Diode électroluminescente (100) selon l'une des revendications précédentes, comportant en outre :
- une portion d'AlGaN non intentionnellement dopé disposée entre la première portion (104) et la zone active (106), et/ou
- une portion d'AIGalnN non intentionnellement dopé disposée entre la zone active (106) et la deuxième portion (108).

7. Diode électroluminescente (100) selon l'une des revendications précédentes, comportant en outre un substrat (102) tel que la première portion (104) soit disposée entre le substrat (102) et la zone active (106).

8. Diode électroluminescente (100) selon la revendication 7, comportant en outre au moins une portion (103) de GaN dopé n disposée entre le substrat (102) et la première portion (104).

9. Diode électroluminescente (100) selon l'une des revendications précédentes, dans laquelle la diode (100) comporte un empilement de couches formant les différentes portions de la diode (100), ou plusieurs nanofils (109) disposés les uns à côté des autres et formant ensemble les différentes portions de la diode (100).

10. Diode électroluminescente (100) selon la revendication 9, dans laquelle, lorsque la diode (100) comporte plusieurs nanofils (109) disposés les uns à côté des autres et formant ensemble les différentes portions de la diode (100), les dimensions latérales des parties (116) des nanofils (109) formant la deuxième portion (108) sont telles qu'elles forment, aux sommets des nanofils (109), une couche (118) de semi-conducteur.

11. Diode électroluminescente (100) selon l'une des revendications précédentes, dans laquelle la zone active (106) comporte une ou plusieurs couches de boîtes quantiques chacune formée d'une couche émissive disposée entre deux couches barrières.

12. Procédé de réalisation d'une diode électroluminescente (100), comportant au moins :
- réalisation d'une première portion (104) de semi-conducteur dopé n ;
- réalisation d'une zone active (106) sur la première portion (104) et comprenant au moins une portion émissive semi-conductrice ;
- réalisation d'une deuxième portion (108) de semi-conducteur dopé p sur la zone active (106) ;
- réalisation, sur la deuxième portion (108), d'une couche (120) électriquement conductrice et optiquement transparente à au moins une longueur d'onde du domaine UV destinée à être émise depuis la portion émissive ;
dans lequel :
- les semi-conducteurs de la première portion (104) et de la portion émissive correspondent à des composés comprenant des atomes d'azote ainsi que des atomes d'aluminium et/ou de gallium ;
- le semi-conducteur de la deuxième portion (108) correspond à de l'Al_{X2}Ga_{(1-X2-Y2)}In_{Y2}N dopé p par des atomes de magnésium, avec X2 > 0, Y2 > 0 et X2+Y2 ≤ 1, et dans lequel la concentration atomique des atomes de magnésium est supérieure à 10¹⁷ at/cm³;
- la couche (120) électriquement conductrice comporte du diamant dopé.

13. Procédé selon la revendication 12, dans lequel la réalisation de la deuxième portion (108) comporte la mise en oeuvre d'un dépôt chimique en phase vapeur aux organométalliques et/ou d'une épitaxie par jets moléculaires.

14. Procédé selon l'une des revendications 12 ou 13, comportant en outre, après la réalisation de la deuxième portion (108), la réalisation d'une troisième portion de semi-conducteur dopé n sur la deuxième portion (108), le semi-conducteur de la troisième portion correspondant à de l'Al_{X3}Ga_{(1-X3-Y3)}In_{Y3}N, avec X3 > 0, Y3 > 0 et X3+Y3 ≤ 1, la couche électriquement conductrice (120) étant réalisée ensuite sur la troisième portion.

15. Procédé selon l'une des revendications 12 à 14, comportant en outre, après la réalisation de la deuxième portion (108), une étape d'activation des dopants du semi-conducteur de la deuxième portion (108) incluant un recuit thermique et/ou une irradiation par faisceau électronique de la deuxième portion (108).

## Patentansprüche

1. Lichtemittierende Diode (100), die mindestens Folgendes umfasst:
- einen ersten n-dotierten Halbleiterabschnitt (104);
- einen zweiten p-dotierten Halbleiterabschnitt (108);
- ein aktives Gebiet (106), das zwischen dem ersten und dem zweiten Abschnitt (104, 108) angeordnet ist und mindestens einen emittierenden Halbleiterabschnitt enthält;
- eine elektrisch leitfähige und optisch transparente Schicht (120) bei mindestens einer Wellenlänge im UV-Bereich, die von dem emittierenden Abschnitt emittiert werden soll, wobei die Schicht (120) derart ist, dass der zweite Abschnitt (108) zwischen der Schicht (120) und dem aktiven Gebiet (106) angeordnet ist;
bei der:
- die Halbleiter des ersten Abschnitts (104) und des emittierenden Abschnitts Verbindungen entsprechen, die Stickstoffatome sowie Aluminium- und/oder Galliumatome enthalten;
- der Halbleiter des zweiten Abschnitts (108) Al_{X2}Ga_{(1-X2-Y2)}In_{Y2}N entspricht, das mit Magnesiumatomen p-dotiert ist, wobei X2 > 0, Y2 > 0 und X2+Y2 ≤ 1, und bei der die Atomkonzentration von Magnesium höher als 10¹⁷ at/cm³ ist;
wobei die lichtemittierende Diode (100) **dadurch gekennzeichnet ist, dass** die elektrisch leitfähige Schicht (120) dotierten Diamant umfasst.

2. Lichtemittierende Diode (100) nach Anspruch 1, bei der:
- Y2 derart ist, dass 0 < Y2 ≤ 0,01, und/oder
- die Atomkonzentration von Magnesium im Halbleiter des zweiten Abschnitts (108) zwischen 10²⁰ at/cm³ und 10²¹ at/cm³ liegt.

3. Lichtemittierende Diode (100) nach einem der vorhergehenden Ansprüche, ferner umfassend einen dritten n-dotierten Halbleiterabschnitt, der zwischen der elektrisch leitfähigen Schicht (120) und dem zweiten Abschnitt (108) angeordnet ist, und bei der der Halbleiter des dritten Abschnitts Al_{X3}Ga_{(1-X3-Y3)}In_{Y3}N entspricht, wobei X3 > 0, Y3 > 0 und X3+Y3 ≤ 1.

4. Lichtemittierende Diode (100) nach einem der vorhergehenden Ansprüche, bei der der Halbleiter des ersten Abschnitts (104) Al_{X1}Ga_{(1-X1)}N entspricht, wobei 0,7 ≤ X1 ≤ 0,9.

5. Lichtemittierende Diode (100) nach dem vorhergehenden Anspruch, bei der der Halbleiter des emittierenden Abschnitts Al_{X4}Ga_{(1-X4)}N entspricht, wobei X4 ≤ 0,9.X1.

6. Lichtemittierende Diode (100) nach einem der vorhergehenden Ansprüche, ferner umfassend:
- einen Abschnitt aus unbeabsichtigt dotiertem AlGaN, der zwischen dem ersten Abschnitt (104) und dem aktiven Gebiet (106) angeordnet ist, und/oder
- einen Abschnitt aus unbeabsichtigt dotiertem AIGalnN, der zwischen dem aktiven Gebiet (106) und dem zweiten Abschnitt (108) angeordnet ist.

7. Lichtemittierende Diode (100) nach einem der vorhergehenden Ansprüche, die ferner ein Substrat (102) derart umfasst, dass der erste Abschnitt (104) zwischen dem Substrat (102) und dem aktiven Gebiet (106) angeordnet ist.

8. Lichtemittierende Diode (100) nach Anspruch 7, die ferner mindestens einen n-dotierten GaN-Abschnitt (103), der zwischen dem Substrat (102) und dem ersten Abschnitt (104) angeordnet ist.

9. Lichtemittierende Diode (100) nach einem der vorhergehenden Ansprüche, bei der die Diode (100) einen Stapel aus Schichten umfasst, die die verschiedenen Abschnitte der Diode (100) bilden, oder mehrere Nanodrähte (109), die nebeneinander angeordnet sind und zusammen die verschiedenen Abschnitte der Diode (100) bilden.

10. Lichtemittierende Diode (100) nach Anspruch 9, bei der, wenn die Diode (100) mehrere Nanodrähte (109) umfasst, die nebeneinander angeordnet sind und zusammen die verschiedenen Abschnitte der Diode (100) bilden, die seitlichen Abmessungen der Teile (116) der Nanodrähte (109), die den zweiten Abschnitt (108) bilden, derart sind, dass sie an den Oberseiten der Nanodrähte (109) eine Halbleiterschicht (118) bilden.

11. Lichtemittierende Diode (100) nach einem der vorhergehenden Ansprüche, bei der das aktive Gebiet (106) eine oder mehrere Quantenpunktschichten umfasst, die jeweils aus einer emittierenden Schicht gebildet sind, die zwischen zwei Sperrschichten angeordnet ist.

12. Verfahren zum Herstellen einer lichtemittierenden Diode (100), das mindestens Folgendes umfasst:
- Herstellen eines ersten n-dotierten Halbleiterabschnitts (104);
- Herstellen eines aktiven Gebiets (106) auf dem ersten Abschnitt (104) und mit mindestens einem emittierenden Halbleiterabschnitt;
- Herstellen eines zweiten p-dotierten Halbleiterabschnitts (108) auf dem aktiven Gebiet (106);
- Herstellen einer elektrisch leitfähigen und optisch transparenten Schicht (120) auf dem zweiten Abschnitt (108) bei mindestens einer Wellenlänge im UV-Bereich, die von dem emittierenden Abschnitt emittiert werden soll;
bei dem:
- die Halbleiter des ersten Abschnitts (104) und des emittierenden Abschnitts Verbindungen entsprechen, die Stickstoffatome sowie Aluminium- und/oder Galliumatome enthalten;
- der Halbleiter des zweiten Abschnitts (108) Al_{X2}Ga_{(1-X2-Y2)}In_{Y2}N entspricht, das mit Magnesiumatomen p-dotiert ist, wobei X2 > 0, Y2 > 0 und X2+Y2 ≤ 1, und bei der die Atomkonzentration von Magnesium höher als 10¹⁷ at/cm³ ist;
- die elektrisch leitfähige Schicht (120) dotierten Diamant umfasst.

13. Verfahren nach Anspruch 12, bei dem das Herstellen des zweiten Abschnitts (108) das Durchführen einer metallorganischen chemischen Gasphasenabscheidung und/oder Molekularstrahlepitaxie umfasst.

14. Verfahren nach einem der Ansprüche 12 oder 13, das ferner nach dem Herstellen des zweiten Abschnitts (108) das Herstellen eines dritten n-dotierten Halbleiterabschnitts auf dem zweiten Abschnitt (108) umfasst, wobei der Halbleiter des dritten Abschnitts Al_{X3}Ga_{(1-X3-Y3)}In_{Y3}N entspricht, wobei X3 > 0, Y3 > 0 und X3+Y3 ≤ 1, wobei die elektrisch leitfähige Schicht (120) anschließend auf dem dritten Abschnitt hergestellt wird.

15. Verfahren nach einem der Ansprüche 12 bis 14, das ferner nach dem Herstellen des zweiten Abschnitts (108) einen Schritt des Aktivierens der Dotierstoffe des Halbleiters des zweiten Abschnitts (108) umfasst, der ein thermisches Glühen und/oder eine Bestrahlung des zweiten Abschnitts (108) mit einem Elektronenstrahl beinhaltet.

## Claims

1. Light-emitting diode (100) comprising at least:
- a first n-doped semiconductor portion (104);
- a second p-doped semiconductor portion (108);
- an active zone (106) disposed between the first and second portions (104, 108) and comprising at least one emitting semiconductor portion;
- a layer (120) that is electrically conductive and optically transparent to at least one wavelength of the UV range configured to be emitted from the emitting portion, said layer (120) being such that the second portion (108) is disposed between said layer (120) and the active zone (106);
wherein:
- the semiconductors of the first portion (104) and of the emitting portion correspond to compounds comprising nitrogen atoms as well as atoms of aluminum and/or of gallium;
- the semiconductor of the second portion (108) corresponds to Al_{X2}Ga_{(1-X2-Y2)}In_{Y2}N that is p-doped with magnesium atoms, with X2 > 0, Y2 > 0 and X2+Y2 < 1, and in which the atomic concentration of magnesium is greater than 10¹⁷ at/cm³;
the light-emitting diode (100) being **characterized in that** the electrically conductive layer (120) comprises doped diamond.

2. Light-emitting diode (100) according to claim 1, wherein:
- Y2 is such that 0 < Y2 ≤ 0.01, and/or
- the atomic concentration of magnesium in the semiconductor of the second portion (108) is comprised between 10²⁰ at/cm³ and 10²¹ at/cm³.

3. Light-emitting diode (100) according to one of the preceding claims, further comprising a third portion of n-doped semiconductor disposed between the electrically conductive layer (120) and the second portion (108), and in which the semiconductor of the third portion comprises Al_{X3}Ga_{(1-X3-Y3)}In_{Y3}N, with X3 > 0, Y3 > 0 and X3+Y3 < 1.

4. Light-emitting diode (100) according to one of the preceding claims, wherein the semiconductor of the first portion (104) corresponds to Al_{X1}Ga_{(1-X1)}N, with 0.7 ≤ X1 ≤ 0.9.

5. Light-emitting diode (100) according to the preceding claim, wherein the semiconductor of the emitting portion corresponds to Al_{X4}Ga_{(1-X4)}N, with X4 ≤ 0.9.X1.

6. Light-emitting diode (100) according to one of the preceding claims, further comprising
- a portion of AlGaN not intentionally doped disposed between the first portion (104) and the active zone (106) , and/or
- a portion of AIGalnN not intentionally doped disposed between the active zone (106) and the second portion (108).

7. Light-emitting diode (100) according to one of the preceding claims, further comprising a substrate (102) such that the first portion (104) is disposed between the substrate (102) and the active zone (106).

8. Light-emitting diode (100) according to claim 7, further comprising at least one portion (103) of n-doped GaN disposed between the substrate (102) and the first portion.

9. Light-emitting diode (100) according to one of the preceding claims, wherein the diode (100) comprises a stack of layers forming the different portions of the diode (100), or several nanowires (109) disposed side by side and forming together the different portions of the diode (100).

10. Light-emitting diode (100) according to claim 9, wherein, when the diode (100) comprises several nanowires (109) disposed side by side and together and forming the different portions of the diode (100), the lateral dimensions of the parts (116) of the nanowires (109) forming the second portion (108) are such that they form, at the tops of the nanowires (109), a semiconductor layer.

11. Light-emitting diode (100) according to one of the preceding claims, wherein the active zone (106) comprises one or more layers of quantum dots each formed by an emitting layer disposed between two barrier layers.

12. Method of producing a light-emitting diode (100) comprising at least:
- producing a first n-doped semiconductor portion (104);
- on the first portion (104), producing an active zone (106) comprising at least one semiconductor emitting portion;
- producing a second p-doped semiconductor portion (108) on the active zone (106);
- producing, on the second portion (108), a layer (120) that is electrically conductive and optically transparent to at least one wavelength of the UV range configured to be emitted from the emitting portion;
wherein:
- the semiconductors of the first portion (104) and of the emitting portion correspond to compounds comprising nitrogen atoms as well as atoms of aluminum and/or of gallium;
- the semiconductor of the second portion (108) comprises Al_{X2}Ga_{(1-X2-Y2)}In_{Y2}N that is p-doped with magnesium atoms, with X2 > 0, Y2 > 0 and X2+Y2 ≤ 1, and in which the atomic concentration of magnesium atoms is greater than 10¹⁷ at/cm³;
- the electrically conductive layer (120) comprises doped diamond.

13. Method according to claim 12, wherein producing the second portion (108) comprises implementation of metalorganic chemical vapor deposition and/or molecular beam epitaxy.

14. Method according to one of claims 12 or 13, further comprising, after producing the second portion (108), producing a third portion of n-doped semiconductor on the second portion (108), the semiconductor of the third portion comprising Al_{X3}Ga_{(1-X3-Y3)}In_{Y3}N, with X3 > 0, Y3 > 0 and X3+Y3 ≤ 1, the electrically conducting layer (120) then being produced on the third portion.

15. A method according to one of claims 12 to 14, further comprising, after producing the second portion (108), a step of activating the dopants of the semiconductor of the second portion (108) including thermal annealing and/or electron beam irradiation of the second portion (108).
